# EUROPEAN PATENT APPLICATION

(11) **EP 4 768 927 A1**
(43) Date of publication of application: **01.07.2026**
(21) Application number: 25816145.4
(22) Date of filing: 21.03.2025
(51) Int. Cl.: G01R 31/317, G01R 31/3185, G01R 31/392, G01R 31/396

(54) **DIAGNOSTIC DEVICE AND OPERATING METHOD THEREOF**

(30) Priority: 29.05.2024 KR 20240070060
(71) Applicant: LG Energy Solution, Ltd., Seoul 07335 (KR)
(72) Inventor: JEONG, Doo Ho, Daejeon 34122 (KR)
(74) Representative: Plasseraud IP
(86) International application number: PCT/KR2025/003672
(87) International publication number: WO 2025/249730

(57) **Abstract**

A diagnosis device according to an embodiment of this document includes a comparator configured to generate an output value based on a result of comparing values input to an inverting terminal and a non-inverting terminal, a first resistor of which a first end is connected to a relay and of which a second end is connected to the inverting terminal of the comparator, a second resistor of which a first end is connected to the relay and of which a second end is connected to the non-inverting terminal of the comparator, and having a resistance value such that when the relay is short-circuited, a voltage applied to the non-inverting terminal becomes greater than a voltage applied to the inverting terminal, and one or more processors configured to control an operation of the relay through a control signal that controls the operation of the relay and diagnose a state of the relay based on an output value of the comparator circuit unit according to an operation of the relay.

## Description

### TECHNICAL FIELD

### Cross-reference to Related Applications

This application claims priority from Korean Patent Application No. 10-2024-0070060, filed on May 29, 2024, the disclosure of which is incorporated by reference herein.

### Technical Field

Embodiments disclosed in this document relate to a diagnosis device and an operating method thereof.

### BACKGROUND ART

Recently, research and development on secondary batteries have been actively conducted. Here, secondary batteries are batteries that can be charged and discharged, and may be interpreted as including both conventional Ni/Cd batteries, Ni/MH batteries, etc. and recent lithium-ion batteries. Recently, the scope of use of the secondary batteries has expanded to include a power source for electric vehicles, and the secondary batteries are attracting attention as a next-generation energy storage medium.

An electric vehicle receives electricity from the outside to charge a battery pack, and then discharge the battery pack to drive a motor and obtain power. An electrical connection between components included in the battery pack (e.g., battery cells, BMS, etc.) may be controlled through a relay. When the failure occurs in the relay during the use of the battery pack, the battery pack may malfunction.

Tests on the relay may be performed for various purposes, such as diagnosing and analyzing a state of the relay. For example, whether a relay has failed can be diagnosed based on voltages at both ends of the relay. However, this method involved a sensor that senses the voltages at both ends of the relay and a processor that stores and processes a value obtained from the sensor, and thus there was a problem that the diagnosis was not easy. Therefore, a technology that can diagnose the state of the relay more simply and accurately is needed.

### DISCLOSURE OF THE INVENTION

### TECHNICAL PROBLEM

Embodiments disclosed in this document provide a diagnosis device capable of diagnosing an operation state of a relay and an operating method thereof.

Embodiments disclosed in this document provide a diagnosis device capable of diagnosing a state of a relay through a comparator and diagnosing whether the relay has failed through a logic gate, and an operating method thereof.

The technical problems of the embodiments disclosed in this document are not limited to the technical problems mentioned above, and other technical problems that are not mentioned may be clearly understood by those skilled in the art from the descriptions below.

### TECHNICAL SOLUTION

A diagnosis device according to an embodiment of this document includes a comparator circuit unit including a comparator configured to generate an output value based on a result of comparing values input to an inverting terminal and a non-inverting terminal, a first resistor of which a first end is connected to a relay and of which a second end is connected to the inverting terminal of the comparator, and a second resistor of which a first end is connected to the relay and of which a second end is connected to the non-inverting terminal of the comparator, and having a resistance value such that when the relay is short-circuited, a voltage applied to the non-inverting terminal becomes greater than a voltage applied to the inverting terminal, and one or more processors configured to control an operation of the relay through a control signal that controls the operation of the relay and diagnose a state of the relay based on an output value of the comparator circuit unit according to an operation of the relay.

According to the embodiment, the first end of the first resistor and the relay may be connected to a first node, and the first end of the second resistor may be configured to be connected to the first node and power may be applied to the first node when the relay is short-circuited.

According to the embodiment, the comparator may be configured to output a logic low value when the value input to the inverting terminal is greater than the value input to the non-inverting terminal, and output a logic high value when the value input to the inverting terminal is less than the value input to the non-inverting terminal.

According to the embodiment, the one or more processors may be configured to determine that the relay is in a short-circuited state when an output value of the comparator is the logic high value, and determine that the relay is in an open state when the output value of the comparator is the logic low value.

According to the embodiment, the diagnosis device may further include a logic gate circuit unit configured to perform a logic operation on the output value of the comparator and the control signal, and the logic gate circuit unit may further include a first NOR gate configured to receive the output value of the comparator and the control signal and output a first value, an AND gate configured to receive the output value of the comparator and the control signal and output a second value, and a second NOR gate configured to receive the first value and the second value and output an output value of the logic gate circuit unit.

According to the embodiment, the one or more processors may be configured to diagnose whether the relay has failed based on the output value of the logic gate circuit.

According to the embodiment, the one or more processors may be configured to diagnose that the relay is in a normal state if the output value of the logic gate circuit is logic low, and diagnose that the relay is in a failure state if the output value of the logic gate circuit is logic high.

An operating method of a diagnosis device according to an embodiment of this document includes applying a control signal controlling an operation of a relay to the relay, and diagnosing a state of the relay based on an output value of the comparator circuit unit according to the operation of the relay in response to the control signal, and the comparator circuit unit includes a comparator configured to generate an output value based on a result of comparing values input to an inverting terminal and a non-inverting terminal, a first resistor of which a first end is connected to the relay and of which a second is connected to the inverting terminal of the comparator, and a second resistor of which a first end is connected to the relay and of which a second end is connected to the non-inverting terminal of the comparator, and having a resistance value such that when the relay is short-circuited, a voltage applied to the non-inverting terminal becomes greater than a voltage applied to the inverting terminal.

According to the embodiment, the first end of the first resistor and the relay may be connected to a first node, and the first end of the second resistor may be configured to be connected to the first node when the relay is short-circuited, and power may be applied to the first node when the relay is short-circuited.

According to the embodiment, the comparator may output a logic low value when the value input to the inverting terminal is greater than the value input to the non-inverting terminal, and may output a logic high value when the value input to the inverting terminal is less than the value input to the non-inverting terminal.

According to the embodiment, the diagnosing of the state of the relay may include determining that the relay is in a short-circuited state when an output value of the comparator is the logic high value, and determining that the relay is in an open state when the output value of the comparator is the logic low value.

According to the embodiment, the operating method may further include a logic gate circuit unit configured to perform a logic operation on an output value of the comparator and the control signal, and the logic gate circuit unit may further include a first NOR gate configured to receive the output value of the comparator and the control signal and output a first value, an AND gate configured to receive the output value of the comparator and the control signal and output a second value, and a second NOR gate configured to receive the first value and the second value and output an output value of the logic gate circuit unit.

According to the embodiment, the diagnosing of the state of the relay may include diagnosing whether the relay has failed based on the output value of the logic gate circuit.

According to the embodiment, the diagnosing of whether the relay has failed may include diagnosing that the relay is in a normal state if the output value of the logic gate circuit is logic low, and diagnosing that the relay is in a failure state if the output value of the logic gate circuit is logic high.

### ADVANTAGEOUS EFFECTS

The diagnosis device and the operating method thereof disclosed in this document capable of diagnosing an operation state of a relay.

Embodiments disclosed in this document provide a diagnosis device and an operating method thereof capable of diagnosing a state of a relay through a comparator and diagnosing whether the relay has failed through a logic gate.

In addition, various effects that can be directly or indirectly identified through this document can be provided.

### BRIEF DESCRIPTION OF THE DRAWINGS

FIG. 1 is a block diagram showing a battery pack according to an embodiment disclosed in this document.
FIG. 2 is a block diagram showing a diagnosis device according to an embodiment disclosed in this document.
FIG. 3 is a block diagram showing a diagnosis circuit unit according to an embodiment disclosed in this document.
FIG. 4 is a circuit diagram of the diagnosis circuit unit according to an embodiment disclosed in this document when a relay is in an open state.
FIG. 5 is a circuit diagram of the diagnosis circuit unit according to an embodiment disclosed in this document when the relay is in a short-circuited state.
FIG. 6 is a truth table showing an operating method of a diagnosis device according to an embodiment disclosed in this document.
FIG. 7 is a flowchart showing an operation of a diagnosis device according to an embodiment disclosed in this document.
FIG. 8 is a block diagram showing a hardware configuration of a computing system for performing an operation method of a diagnosis device according to an embodiment disclosed in this document.

### MODE FOR CARRYING OUT THE INVENTION

Hereinafter, embodiments described in this document are described with reference to the accompanying drawings. However, this is not intended to limit the disclosure of this document to a specific embodiment, but should be understood to include various modifications, equivalents, and/or alternatives of the embodiments of the present invention.

Various embodiments of this document and the terms used therein are not intended to limit the technical features described in this document to a specific embodiment, but should be understood to include various modifications, equivalents, or alternatives of the embodiment.

In connection with the description, similar reference numerals may be used for similar or related components. The singular form of a noun corresponding to an item may include one or more of said items, unless the context clearly indicates otherwise.

In this document, each of phrases "A or B", "at least one of A and B", "at least one of A or B", "A, B, or C", "at least one of A, B, and C", and "at least one of A, B, or C" may include any one of the items listed together in that phrase, or all possible combinations thereof. Terms such as "first", "second", "firstly", "secondly", "A", "B", "(a)", or "(b)" may be used merely to distinguish one component from another, and do not limit the components in any other respect (e.g., importance or order) unless specifically stated otherwise.

In this document, when a component (e.g., a first component) is referred to as being "connected", "coupled" or "joined" to another component (e.g., a second component), with or without the terms "functionally" or "communicatively", it means that the component can be connected to the other component directly (e.g., in a wired manner), or wirelessly or through a third component.

According to an embodiment, the method according to various embodiments disclosed in this document may be provided by being included in a computer program product. The computer program product may be traded between a seller and a buyer as a product. The computer program product may be distributed in the form of a machine-readable storage medium (e.g., compact disc read only memory (CD-ROM)), or may be distributed online (e.g., downloaded or uploaded) through an application store or directly between two user devices. In the case of online distribution, at least a part of the computer program product may be temporarily stored or temporarily generated in a machine-readable storage medium such as a memory of a manufacturer's server, an application store's server, a relay server.

According to various embodiments, each of the components (e.g., modules or programs) described above may include a single or plurality of entities, and some of the plurality of entities may be separated and placed in other components. According to various embodiments, one or more of the components or operations described above may be omitted, or one or more other components or operations may be added. Alternatively or additionally, a plurality of components (e.g., modules or programs) may be integrated into a single component. In such a case, the integrated component may perform one or more functions of each of the plurality of components identically or similarly to those performed by the corresponding component among the plurality of components prior to the integration. According to various embodiments, the operations performed by a module, program, or other component may be performed sequentially, in parallel, repeatedly, or heuristically, or one or more of the operations may be performed in a different order, omitted, or performed by being added with one or more other operations.

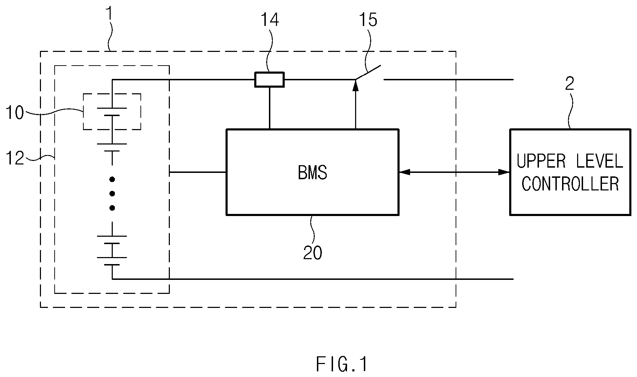

FIG. 1 is a block diagram showing a battery pack according to an embodiment disclosed in this document.

Referring to FIG. 1, a battery pack 1 may include a battery unit 12, a sensor unit 14, a switching unit 16, and a battery management system (BMS) 20. In this case, the battery pack 1 may be provided with a plurality of battery units 12, sensor units 14, switching units 16, and battery management systems 20.

According to the embodiment, the battery unit 12 may supply power to a target device (not shown). To this end, battery unit 12 may be electrically connected to the target device. Here, the target device may include an electrical, electronic, or mechanical device that operates by receiving power from the battery pack 1. For example, the target device may be an electric vehicle (EV), but is not limited thereto.

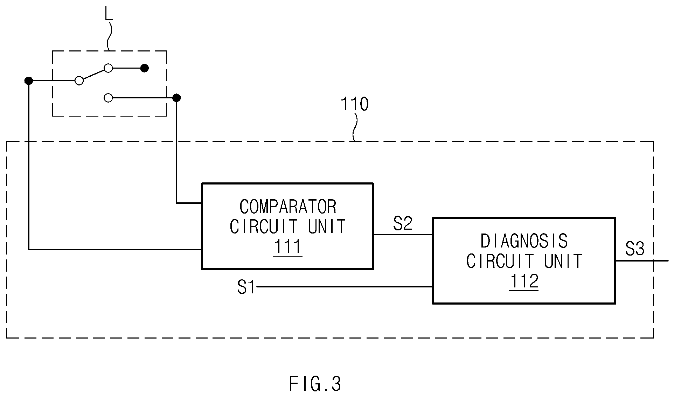

According to the embodiment, the battery unit 12 may include at least one battery cell 10 that can be charged and discharged. Here, the battery cell 10 may be a basic unit of a battery cell that can be used by charging and discharging electric energy. For example, the battery cell 10 may be a lithium-ion (Li-ion) battery, a lithium-ion polymer (Li-ion polymer) battery, a nickel-cadmium (Ni-Cd) battery, a nickel-metal hydride (Ni-MH) battery, etc., but is not limited thereto. The description of a detailed structure of the battery cell 10 will be made with reference to FIG. 3.

According to the embodiment, a plurality of battery units 12 may be connected in series or in parallel with each other. For example, the battery unit 12 may be a battery module, a battery bank, or a set of battery cells (cell-to-pack structure).

According to the embodiment, the sensor unit 14 may obtain information related to the battery unit 12. According to the embodiment, the sensor unit 14 may obtain values (or information) related to a state of each battery unit 12. In an embodiment, the values related to the state may include one or more values for voltage, current, resistance, state of charge (SOC), state of health (SOH), or temperature of the battery cell, or a combination thereof.

According to the embodiment, the sensor unit 14 may provide information on each of a plurality of battery units 12 to the battery management system 20.

According to the embodiment, the switching unit 16 may include a device for controlling a current flow for charging or discharging the battery unit 12. For example, the switching unit 16 may include at least one relay and/or magnetic contactor, etc., depending on the specifications of the battery pack 1.

According to the embodiment, the battery management system (BMS) 20 may control or manage the battery pack 1 to prevent overcharge and overdischarge by monitoring the voltage, current, temperature, etc. of the battery pack 1. For example, the battery management system 20 is an interface that receives values obtained by measuring various parameters described above, and may include a plurality of terminals, a circuit connected to these terminals to process the received values, etc. In addition, the battery management system 20 may control the sensor unit 14 and/or the switching unit 16. For example, the battery management system 20 may be connected to the plurality of battery units 12 to monitor the state of each of the plurality of battery units 12 and control ON/OFF of a relay or a contactor.

According to the embodiment, an operation of the battery management system 20 may be performed by the battery management system (BMS) in a vehicle, and may also be performed in various devices such as a server, a cloud, a charger, or a charger/discharger.

An upper level controller 2 may transmit a control signal for the plurality of battery units 12 to the battery management system 20. Accordingly, the operation of the battery management system 20 may be controlled based on the signal received from the upper level controller 2.

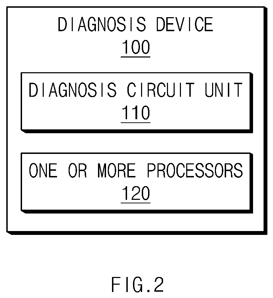

According to the embodiment, the battery management system 20 may include a diagnosis device 100 of FIG. 2. According to another embodiment, the battery management system 20 may be a different system from the diagnosis device 100 of FIG. 2. That is, the diagnosis device 100 of FIG. 2 may be included in the battery pack 1 or may be configured as another device external to the battery pack 1. Hereinafter, for convenience of description, the description will be made on the assumption that the diagnosis device 100 is composed of another device external to the battery pack 1. In addition, the operation of the diagnosis device 100 below may be performed by a battery management system (BMS) in the vehicle, and may also be performed in various devices such as a server, a cloud, a charger, or a charger/discharger.

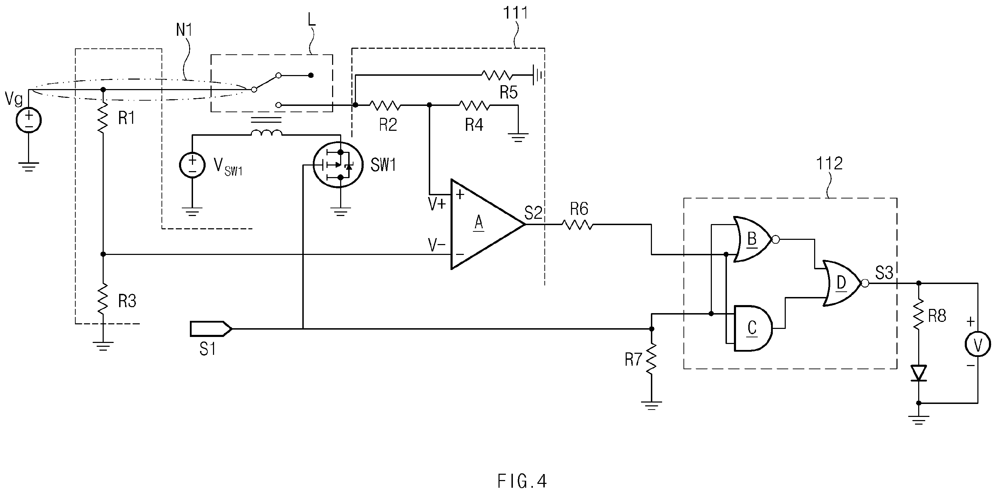

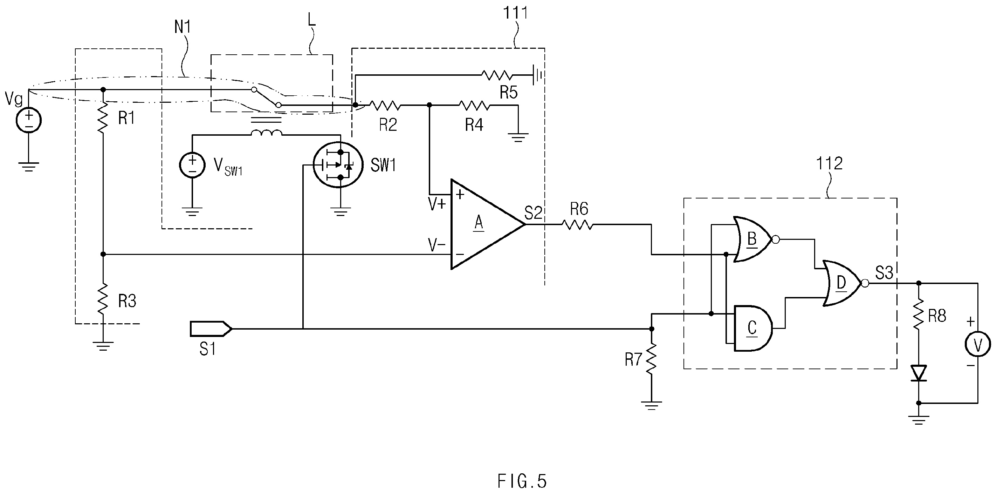

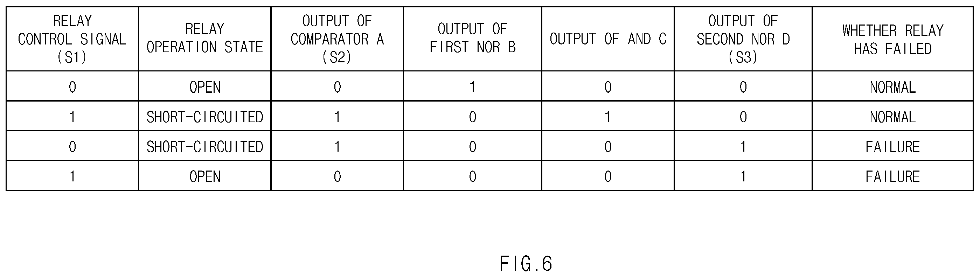

FIG. 2 is a block diagram showing a diagnosis device according to an embodiment disclosed in this document. FIG. 3 is a block diagram showing a diagnosis circuit unit according to an embodiment disclosed in this document. FIG. 4 is a circuit diagram of a diagnosis circuit unit according to an embodiment disclosed in this document when a relay is in an open state, and FIG. 5 is a circuit diagram of a diagnosis circuit unit according to an embodiment disclosed in this document when the relay is in a short-circuited state. FIG. 6 is a truth table showing an operating method of a diagnosis device according to an embodiment disclosed in this document. The description of an operation of the diagnosis device illustrated in FIG. 2 will be made in detail with reference to FIG. 3 and FIG. 6 below.

First, referring to FIG. 2, a diagnosis device 100 according to an embodiment disclosed in this document may include a diagnosis circuit unit 110 and one or more processors 120. However, it is not limited thereto, and other components may be further included in the diagnosis device 100, two or more components may be integrated into one, or one component may be divided into two or more components.

According to the embodiment, the diagnosis device 100 may diagnose a state of a relay L. For example, a defect occurs in the relay L due to various causes such as a fault in the production stage, a failure in the use stage, or an external impact. The diagnosis device 100 according to the embodiment may diagnose an abnormality of the relay L using the diagnosis circuit unit 110 configured to be electrically connected to both ends of the relay L.

According to the embodiment, the diagnosis circuit unit 110 may output a signal related to a state of the relay L based on the voltage of the relay L. For example, the diagnosis circuit unit 110 may output a signal related to an operation state of the relay L and/or a signal related to whether there is a failure of the relay L. Here, the operation state may include an open state in which the relay L is open and a short-circuited state in which the relay L is short-circuited. In addition, whether there is a failure of the relay L may mean whether the relay L operates in response to a control signal S1 that controls the operation of the relay L. For example, when the operation of the control signal S1 and the relay L correspond to each other, the relay L may be in a normal state, and when the operation of the control signal S1 and the relay L do not correspond to each other, the relay L may be in a failure state.

Referring to FIG. 3, the diagnosis circuit unit 110 may include a comparator circuit unit 111 and a logic gate circuit unit 112. According to the embodiment, the comparator circuit unit 111 may receive voltages at both ends of the relay as input and output a signal S2 related to an operation state of the relay L. In addition, according to the embodiment, the logic gate circuit unit 112 may receive the control signal S1 and an output value S2 of the comparator circuit unit 111 as input and output a signal S3 related to whether the relay L has failed. The description of the configuration of the comparator circuit unit 111 and the logic gate circuit unit 112 according to an embodiment will be made with reference to FIGS. 4 and 5.

Referring to FIG. 4, the relay L may operate in response to the control signal S1. According to the embodiment, the control signal S1 may be logic low or logic high. Here, a logic value of the control signal S1 may be determined by one or more processors 120 (see FIG. 2). According to the embodiment, one or more processors 120 may output the control signal S1 to a first switch SW1.

For example, when the control signal S1 is logic low, the first switch SW1 to which the control signal S1 is applied may enter an open state, and no magnetic force may be induced in the relay L. Here, the first switch SW1 may be composed of a field effect transistor (FET). Therefore, when the control signal S1 is logic low, the relay L may be in an open state.

In contrast, when the control signal S1 is logic high, the first switch SW1 to which the control signal S1 is applied may enter a short-circuited state, and an induced electromotive force for driving a relay may be applied to the relay L. Therefore, the relay L may enter a short-circuited state by the induced electromotive force. Here, the induced electromotive force may mean an electromotive force induced by a voltage source V_{SW1}. In addition, the voltage source V_{SW1} may be a 12 V or 24 V voltage source, but is not limited thereto.

According to the embodiment, the comparator circuit unit 111 may include a comparator A configured to be connected to the relay L. For example, the comparator A may generate the output value S2 based on a result of comparing a value V- input to an inverting terminal (-) and a value V+ input to a non-inverting terminal (+). According to the embodiment, the comparator A may compare the value V- input to the inverting terminal and the value V+ input to the non-inverting terminal, and output a logic low value when the value V- input to the inverting terminal is greater than the value V+ input to the non-inverting terminal. In addition, the comparator A may output a logic high value when the value V- input to the inverting terminal is less than the value V+ input to the non-inverting terminal.

According to the embodiment, the inverting terminal (-) of the comparator A may be connected to one end of the relay L, and the non-inverting terminal (+) may be connected to the other end of the relay L. Therefore, since the two input terminals of the comparator A may be respectively connected to one end and the other end of the relay L, the comparator circuit unit 111 may compare the voltages at both ends of the relay L through the comparator A. Through this, the comparator circuit unit 111 may compare the voltages at both ends of the relay L through the comparator A without a sensor that senses the voltage of the relay L and a separate processor (or MCU) that compares the voltage values. In addition, this comparator circuit unit 111 may increase the degree of integration of the circuit and may reduce the cost because it does not require a separate processor.

According to the embodiment, the comparator circuit unit 111 may be configured so that the magnitude of the voltages respectively applied to input terminals (inverting terminal and non-inverting terminal) of the comparator A are different in each of the short-circuited state and the open state of the relay L. For example, when the relay L is in a short-circuited state, the comparator circuit unit 111 may be configured so that the voltage V+ applied to the non-inverting terminal (+) of the comparator A is greater than the voltage V- applied to the inverting terminal (-). On the other hand, when the relay L is in an open state, the comparator circuit unit 111 may be configured so that the voltage V+ applied to the non-inverting terminal (+) is less than the voltage V- applied to the inverting terminal (-).

According to the embodiment, the comparator circuit unit 111 may include one or more resistors R1 to R5 configured so that the magnitudes of the voltages respectively applied to the input terminals of the comparator A are different in each operation state of the relay L. Through this, the diagnosis device 100 may compare the voltages at both ends of the relay L through the comparator A without a sensor that senses the voltage of the relay L and a separate processor (or MCU) that compares the voltage value. In addition, the diagnosis device 100 may increase the degree of integration of the comparator circuit unit 111 and reduce the cost.

According to the embodiment, the comparator circuit unit 111 may include a first resistor R1 connected to the inverting terminal (-) of the comparator A and a second resistor R2 connected to the non-inverting terminal (+) thereof. For example, the first end of the first resistor R1 may be connected to the relay L, and the second end thereof may be connected to the inverting terminal (-) of the comparator A. In addition, the first end of the second resistor R2 may be connected to the relay L, and the second end thereof may be connected to the non-inverting terminal (+) of the comparator A.

According to the embodiment, the second resistor R2 may have a resistance value that makes the voltage V+ applied to the non-inverting terminal greater than the voltage V-applied to the inverting terminal when the relay L is short-circuited. Therefore, other resistors (e.g., R3 to R5) other than the first resistor R1 and the second resistor R2 may be appropriately changed according to the resistance value of the first resistor R1 and the resistance value of the second resistor R2.

According to the embodiment, the relay L may be connected to a power source Vg. Here, the power source Vg may mean a power source configured to apply a current through the relay L when the relay L switches from an open state to a short-circuited state, or a signal source configured to apply a signal. In the embodiment of FIG. 4, the power source Vg is illustrated as a voltage source, but is not limited thereto. For example, the power source may be a battery cell 10 or a battery unit 12, or may be any electronic device such as a sensor or a controller.

According to the embodiment, the relay L and the first end of the first resistor R1 may be connected to a first node N1. In addition, the first node N1 may be configured to be applied with the power source Vg. For example, referring to FIG. 4, regardless of the operation state (the open state and the short-circuited state) of the relay L, the current or signal of the power source Vg may be applied to the first node N1. Therefore, regardless of the operation state of the relay L, the current or signal of the power source Vg may be applied to the inverting terminal (-) of the comparator A connected to the first node N1. In another aspect, when the relay L is in the open state, the current or signal of the power source Vg may not be applied to the non-inverting terminal (+). Therefore, when the relay L is in the open state, the voltage V+ applied to the non-inverting terminal of the comparator A may be less than the voltage V- applied to the inverting terminal thereof. In addition, the comparator A may output logic low as the output value S2.

In contrast, referring to FIG. 5, when the relay L is short-circuited, the first end of the second resistor R2 may be configured to be connected to the first node N1. Therefore, when the relay L is in the short-circuited state, the current or signal of the power source Vg may be applied to both the non-inverting terminal (+) and the inverting terminal (-). In addition, the voltage V+ applied to the non-inverting terminal of the comparator A by the first resistor R1 to the fifth resistor R5 may be greater than the voltage V- applied to the inverting terminal. Therefore, when the relay L is in the short-circuited state, the comparator A may output logic high as the output value S2.

According to the embodiment, a logic gate circuit unit 112 may include a logic gate. Here, the logic gate may mean a logic circuit such as an AND gate, an OR gate, a NOT gate, a NAND gate, a NOR gate, an XNOR gate, and an XOR gate. For example, the logic gate circuit unit 112 may include one or more logic gates.

According to the embodiment, the logic gate circuit unit 112 may logically determine whether the relay L has failed based on the output value S2 of the comparator circuit unit 111. For example, the logic gate circuit unit 112 may perform a logical operation on whether the output value S2 of the comparator A corresponds to the control signal S1. Here, the control signal S1 that is an input of the logic gate circuit unit 112 may be the same as the control signal S1 applied to the first switch SW1 to control the operation of the relay L.

According to the embodiment, the control signal S1 may be logic low or logic high. Here, a logic value of the control signal S1 may be determined by one or more processors 120 (see FIG. 2). According to the embodiment, one or more processors 120 may output the control signal S1 to an input terminal of the logic gate circuit unit 112.

According to the embodiment, the logic gate circuit unit 112 may determine whether the control signal S1 and the output value S2 of the comparator A correspond to each other. According to the embodiment, the logic gate may perform a logic operation on the control signal S1 and the output value S2 of the comparator A, and output logic low as the output value S3 of the logic gate when the output value S2 of the comparator A and the control signal S1 correspond to each other. Here, the case where the output value S2 of the comparator A and the control signal S1 correspond to each other may include a case where both the output value S2 and the control signal S1 are logic low or a case where both the output value S2 and the control signal S1 are logic high.

According to the embodiment, the logic gate may output logic high as the output value S3 of the logic gate when the output value S2 of the comparator A and the control signal S1 do not correspond to each other. Here, the case where the output value S2 of the comparator A and the control signal S1 do not correspond to each other may include a case where the output value S2 is logic low and the control signal S1 is logic high or a case where the output value S2 is logic high and the control signal S1 is logic low.

Through this, the logic gate circuit unit 112 may increase the degree of integration of the circuit through a logic gate that does not require a separate memory device. In addition, the logic gate circuit unit 112 may reduce the cost because it does not require a separate processor for logical operations.

According to the embodiment, the logic gate circuit unit 112 may include, but is not limited to, two NOR gates and an AND gate. For example, the logic gate circuit unit 112 may include any combination of logic gates configured to calculate whether the logic value of the control signal S1 and the logic value of the output value S2 of the comparator A correspond to each other.

According to the embodiment, the logic gate may include a first NOR gate B, a second NOR gate D, and an AND gate C. Here, the first NOR gate B may receive the output value S2 of the comparator A and the control signal S1 and output a first value. In addition, the AND gate C may receive the output value S2 of the comparator A and the control signal S1 and output a second value. In addition, the second NOR gate D may receive the first value and the second value and output the output value S3 of the logic gate circuit unit 112. Therefore, the output of each of the first NOR gate B, the second NOR gate D, and the AND gate C according to the output value S2 of the comparator A and the control signal S1 may be understood by referring to the truth table illustrated in FIG. 6.

Referring again to FIG. 2, the diagnosis device 100 may include one or more processors 120 electrically connected to the diagnosis circuit unit 110. According to the embodiment, the one or more processors 120 may perform operations of the diagnosis device 100.

Referring to FIG. 4 and FIG. 6 together, the one or more processors 120 may control the operation of the relay L through the control signal S1 that controls the operation of the relay L. For example, the one or more processors 120 may output, as the control signal S1, a logic high (e.g., 1) signal that short-circuits the relay L or a logic low (e.g., 0) signal that opens the relay L.

According to the embodiment, the one or more processors 120 may diagnose and/or display a state of the relay L based on the output of the diagnosis circuit unit 110. For example, one or more processors 120 may diagnose and display the operation state of the relay L based on the output value S2 of the comparator A according to the operation of the relay L. Here, the operation state of the relay L may include an open state and a short-circuited state. For example, one or more processors 120 may determine that the relay L is in the short-circuited state when the output value S2 of the comparator A is a logic high (1) value. In addition, one or more processors 120 may determine that the relay L is in the open state when the output value S2 of the comparator A is a logic low (0) value.

According to the embodiment, one or more processors 120 may diagnose and display whether the relay L has failed based on the output value S3 of the logic gate. Here, whether the relay L has failed may include a failure state and a normal state of the relay L. For example, one or more processors 120 may diagnose that the relay L is in the normal state if the output value S3 of the logic gate is logic low (0). In addition, one or more processors 120 may diagnose that the relay L is in the failure state if the output value S3 of the logic gate is logic high (1).

According to the embodiment, one or more processors 120 may display the determined state of the relay L to the user or, if necessary, generate a warning signal to notify that the relay L needs to be replaced or maintained. For example, one or more processors 120 may transmit a signal regarding the operation state of the relay L and/or whether the relay L has failed to a separate controller. In addition, one or more processors 120 may display the operation state of the relay L and/or whether the relay L has failed through a diode E, an LED, or a display.

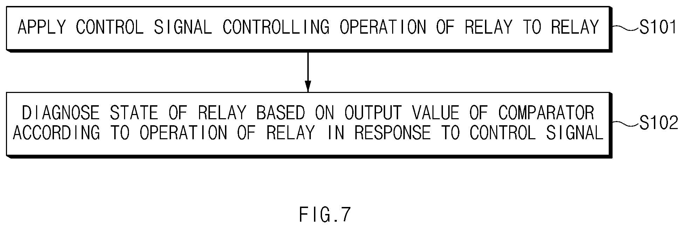

FIG. 7 is a flowchart showing the operation of a diagnosis device according to an embodiment disclosed in this document.

Referring to FIG. 7, the diagnosis device 100 may apply a control signal controlling the operation of the relay to the relay (S101), and diagnose a state of the relay based on an output value of the comparator according to the operation of the relay in response to the control signal (S102).

In step S101, one or more processors 120 of the diagnosis device 100 may apply a control signal S1 controlling the operation of a relay L to the relay L (S101).

In step S102, one or more processors 120 of the diagnosis device 100 may diagnose the state of the relay L based on an output value S2 of the comparator A according to the operation of the relay L in response to a control signal S1 (S102). Here, the state of the relay L may mean the operation state of the relay L including the open state and the short-circuited state of the relay. In addition, one or more processors 120 may diagnose whether the relay has failed based on an output value S3 of a logic gate.

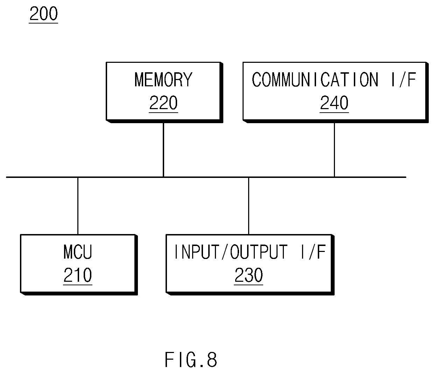

FIG. 8 is a block diagram showing a hardware configuration of a computing system for performing an operating method of a diagnosis device according to an embodiment disclosed in this document.

Referring to FIG. 8, a computing system 200 according to an embodiment disclosed in this document may include an MCU 210, a memory 220, an input/output I/F 230, and a communication I/F 240.

The MCU 210 may be a processor that executes various programs (e.g., data collection programs, data analysis programs, diagnosis programs, etc.) stored in the memory 220, processes various information including diagnosis data, etc. through these programs, and performs the functions of the diagnosis device 100 shown in FIGS. 1 to 7 described above.

The memory 220 may store various programs such as the data collection program, data analysis program, diagnosis programs, etc.

A plurality of such memories 220 may be provided as needed. The memory 220 may be a volatile memory or a nonvolatile memory. The memory 220 as the volatile memory may be RAM, DRAM, SRAM, or the like. The memory 220 as the nonvolatile memory may be ROM, PROM, EAROM, EPROM, EEPROM, flash memory, etc. The examples of the memories 220 listed above are only examples and are not limited to these examples.

The input/output I/F 230 may provide an interface that allows data to be transmitted and received between an input device (not shown) such as a keyboard, mouse, or touch panel, and an output device (not shown) such as a display and the MCU 210.

The communication I/F 240 is a configuration that can transmit and receive various data with the server, and may be various devices that can support wired or wireless communication. For example, the diagnosis device 100 may transmit and receive various information, including data for diagnosis, to and from a separately provided external server through the communication I/F 240.

In this way, the computer program according to an embodiment disclosed in this document may be implemented as a module that performs each function shown in FIG. 2, for example, by being recorded in the memory 220 and processed by the MCU 210.

In the above, even though all the components constituting the embodiments disclosed in this document have been described as being combined as one or operating in combination, the embodiments disclosed in this document are not necessarily limited to these embodiments. That is, within the scope of the purpose of the embodiments disclosed in this document, all of the components may be selectively combined and operated in combination with one or more components.

The terms "include," "configure," or "have" described above, unless specifically stated to the contrary, mean that the corresponding component may be included, and therefore should be interpreted as further including other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

The disclosure described above outlines features of several embodiments so that those skilled in the art may better understand the aspects of the present disclosure. Those skilled in the art will understand that the present disclosure may easily be used as a basis for designing or modifying other structures to perform the same purposes or achieve the same advantages of the embodiments introduced herein. Furthermore, those skilled in the art will recognize that such equivalent configurations do not depart from the scope of the present disclosure, and that various changes, substitutions, and modifications may be made herein without departing from the scope of the present disclosure.

## Claims

1. A diagnosis device comprising:
a comparator circuit unit including
a comparator configured to generate an output value based on a result of comparing values input to an inverting terminal and a non-inverting terminal,
a first resistor of which a first end is connected to a relay and of which a second end is connected to the inverting terminal of the comparator, and
a second resistor of which a first end is connected to the relay and of which a second end is connected to the non-inverting terminal of the comparator, and having a resistance value such that when the relay is short-circuited, a voltage applied to the non-inverting terminal becomes greater than a voltage applied to the inverting terminal; and
one or more processors configured to control an operation of the relay through a control signal that controls the operation of the relay and diagnose a state of the relay based on an output value of the comparator circuit unit according to an operation of the relay.

2. The diagnosis device of claim 1, wherein the first end of the first resistor and the relay are connected to a first node, and
the first end of the second resistor is configured to be connected to the first node when the relay is short-circuited, and power is applied to the first node when the relay is short-circuited.

3. The diagnosis device of claim 1, wherein the comparator is configured to:
output a logic low value when the value input to the inverting terminal is greater than the value input to the non-inverting terminal; and
output a logic high value when the value input to the inverting terminal is less than the value input to the non-inverting terminal.

4. The diagnosis device of claim 3, wherein the one or more processors is configured to:
determine that the relay is in a short-circuited state when an output value of the comparator is the logic high value; and
determine that the relay is in an open state when the output value of the comparator is the logic low value.

5. The diagnosis device of claim 1, further comprising:
a logic gate circuit unit configured to perform a logic operation on the output value of the comparator and the control signal,
wherein the logic gate circuit unit further includes:
a first NOR gate configured to receive the output value of the comparator and the control signal and output a first value;
an AND gate configured to receive the output value of the comparator and the control signal and output a second value; and
a second NOR gate configured to receive the first value and the second value and output an output value of the logic gate circuit unit.

6. The diagnosis device of claim 5, wherein the one or more processors is configured to diagnose whether the relay has failed based on the output value of the logic gate circuit.

7. The diagnosis device of claim 6, wherein the one or more processors is configured to:
diagnose that the relay is in a normal state if the output value of the logic gate circuit is logic low; and
diagnose that the relay is in a failure state if the output value of the logic gate circuit is logic high.

8. An operating method of a diagnosis device, comprising:
applying a control signal controlling an operation of a relay to the relay; and
diagnosing a state of the relay based on an output value of a comparator circuit unit according to the operation of the relay in response to the control signal,
wherein the comparator circuit unit includes:
a comparator configured to generate an output value based on a result of comparing values input to an inverting terminal and a non-inverting terminal;
a first resistor of which a first end is connected to the relay and of which a second end is connected to the inverting terminal of the comparator; and
a second resistor of which a first end is connected to the relay and of which a second end is connected to the non-inverting terminal of the comparator, and having a resistance value such that when the relay is short-circuited, a voltage applied to the non-inverting terminal becomes greater than a voltage applied to the inverting terminal.

9. The operating method of claim 8, wherein the first end of the first resistor and the relay is connected to a first node, and the first end of the second resistor is configured to be connected to the first node when the relay is short-circuited, and power is applied to the first node when the relay is short-circuited.

10. The operating method of claim 8, wherein the comparator is configured to:
output a logic low value when the value input to the inverting terminal is greater than the value input to the non-inverting terminal; and
output a logic high value when the value input to the inverting terminal is less than the value input to the non-inverting terminal.

11. The operating method of claim 10, wherein the diagnosing of the state of the relay includes:
determining that the relay is in a short-circuited state when an output value of the comparator is the logic high value; and
determining that the relay is in an open state when the output value of the comparator is the logic low value.

12. The operating method of claim 8, further comprising:
a logic gate circuit unit configured to perform a logic operation on an output value of the comparator and the control signal,
wherein the logic gate circuit unit further includes:
a first NOR gate configured to receive the output value of the comparator and the control signal and output a first value;
an AND gate configured to receive the output value of the comparator and the control signal and output a second value; and
a second NOR gate configured to receive the first value and the second value and output an output value of the logic gate circuit unit.

13. The operating method of claim 12, wherein the diagnosing of the state of the relay includes diagnosing whether the relay has failed based on the output value of the logic gate circuit.

14. The operating method of claim 13, wherein the diagnosing of whether the relay has failed includes:
diagnosing that the relay is in a normal state if the output value of the logic gate circuit is logic low; and
diagnosing that the relay is in a failure state if the output value of the logic gate circuit is logic high.
